# EUROPÄISCHE PATENTSCHRIFT

(11) **EP 2 556 591 B1**
(45) Veröffentlichungstag und Bekanntmachung des Hinweises auf die Patenterteilung: **17.09.2014**
(21) Anmeldenummer: 11711865.3
(22) Anmeldetag: 29.03.2011
(51) Int. Cl.: H03K 17/955, H03K 17/96

(54) **KAPAZITIVER ANNÄHERUNGSSENSOR**
CAPACITIVE PROXIMITY SWITCH
CAPTEUR DE PROXIMITÉ CAPACITIF

(30) Priorität: 06.04.2010 DE 102010013947
(43) Veröffentlichungstag der Anmeldung: 13.02.2013
(73) Patentinhaber: Continental Automotive GmbH, 30165 Hannover (DE)
(72) Erfinder: SANTAROSSA, Bruno, 63694 Limeshain (DE)
(86) Internationale Anmeldenummer: PCT/EP2011/054822
(87) Internationale Veröffentlichungsnummer: WO 2011/124507

(56) Entgegenhaltungen:
- EP-A2- 1 672 797
- EP-A2- 2 141 808
- DE-A1-102006 039 133
- DE-A1-102008 029 567
- US-A1- 2008 012 734

## Beschreibung

Die Erfindung bezieht sich auf einen kapazitiver Annäherungssensor mit einem einen oder mehrere durchscheinende Bereiche aufweisenden Anzeigefeld, auf deren einem Beobachter abgewandter Seite eine erste Leiterplatte angeordnet ist, die zumindest im Bereich der durchscheinenden Bereiche des Anzeigefelds lichtdurchscheinend ausgebildet ist und kapazitätsbildende Sensorschichten trägt, mit Lichtschächten, die auf der dem Beobachter abgewandten Seite die Sensorschichten umschließen und von der ersten Leiterplatte bis zu einer sich in einem Abstand parallel zur ersten Leiterplatte erstreckenden zweiten Leiterplatte ragen, wobei auf der zweiten Leiterplatte innerhalb der Lichtschächte Lichtquellen angeordnet sind und wobei von der ersten Leiterplatte ein Kontaktelement zur zweiten Leiterplatte führt.

Derartige kapazitive Annäherungssensoren dienen zur Erzeugung einer Kapazitätsänderung bei Annäherung insbesondere einer Hand einer Person durch Auswerten des Messsignals durch eine Steuer- und Auswerteeinheit.

Zum leichteren Auffinden des oder der Sensorbereiche dienen dabei die beleuchtbaren transparenten oder durchscheinenden Bereiche des Anzeigefelds.

Aus DE 10 2008 029 567 A1 ist ein beleuchteter kapazitiver Annäherungssensor mit einer Lichtquelle bekannt. Die Lichtquelle dient der Hinterleuchtung eines transparenten oder durchscheinenden Abschnitts eines Anzeigefeldes. Das Anzeigefeld ist mit seiner Oberfläche einem Bediener zugewandt. Eine leitende, kapazitätsbildende Sensorschicht ist durchscheinend oder transparent. Die Sensorschicht ist in einem Strahlengang des Lichtes von der Lichtquelle durch den zu hinterleuchtenden Abschnitt angeordnet.

Aufgabe der Erfindung ist es einen kapazitiven Annäherungssensor zu schaffen, der einen kompakten, einfach und preiswert herstellbaren Aufbau besitzt, eine gute Empfindlichkeit bei Annäherung der Hand eines Beobachters aufweist und ein leichtes Auffinden der Sensorbereiche ermöglicht.

Diese Aufgabe wird erfindungsgemäß gelöst mit einem die Merkmale des Anspruchs 1 aufweisenden kapazitiven Annäherungssensor.

Die beleuchteten Bereiche im direkten Umfeld oder sogar im Bereich der Sensorschichten ermöglichen ein leichtes Auffinden der Sensorbereicht.

Da die Sensorschichten sich nahe der dem Beobachter nächsten Schicht des Annäherungssensors befinden, wird eine hohe Empfindlichkeit bei Annäherung der Hand des Beobachters erzielt.

Durch den oder die Spritzgussschritte sind nur wenige Montageschritte bei der Herstellung des Annäherungssensors erforderlich.

Der durch Umspritzen der Lichtleiter und der ersten Leiterplatte erzeugte Funktionsträger erfüllt eine Mehrfachfunktion, indem durch ihn nicht nur die Halterung der Lichtleiter und der ersten Leiterplatte erfolgt, sondern gleichzeitig auch die Lichtschächte gebildet werden.

Weiterhin kann der Funktionsträger auch zur Befestigung der zweiten Leiterplatte und ggf. weiterer Elemente wie z.B. von Drehstellern dienen.

Die Durchbrüche in der Dekorschicht können auf jede geeignete Weise erzeugt werden.

Besonders einfach und geeignet können die Durchbrüche mittels eines Laserverfahrens erzeugt werden.

Die Lichtquellen sind vorzugsweise LEDs, die durch SMD-Bauweise leicht bestückbar sind, eine nur geringe Wärmeentwickelung, eine hohe Haltbarkeit und einen geringen Stromverbrauch aufweisen.

Sind die Lichtleiter und der Funktionsträger beoabachterseitig überdeckend mit einer transparenten Kunststoffschicht in Foliendicke überspritzt, auf die die Dekorschicht aufgebracht ist, so werden Einfallstellen an den Lichtleitern und dem Funktionsträger und in den Grenzbereichen zwischen Lichtleitern und Funktionsträger sowie Höhenunterschiede zur Beobachterseite hin von Lichtleitern und Funktionsträger ausgeglichen und eine gleichmäßige Ebene zur Beobachterseite hin erhalten.

In besonders einfacher Weise ist die Dekorschicht eine Lackschicht.

Ist die erste Leiterplatte eine flexible Leiterplatte, so führt dies zu einem geringen Bauraum.

Weiterhin wird es dadurch ermöglicht, die flexible erste Leiterplatte vor dem Anordnen der Lichtleiter und dem Umspritzen des Funktionsträgers z.B. durch Tiefziehen in eine 3-D-Kontur zu verformen, so dass auch die dem Beobachter zugewandte Seite des Funktionsträgers und damit das Anzeigefeld eine 3-D-Kontur erhalten kann.

Weiterhin kann eine Verlängerung des einen Endes der flexiblen Leiterplatte das zur zweiten Leiterplatte führende Kontaktelement bilden.

Zum farbigen Leuchten der Lichtleiter können diese einfarbig oder mehrfarbig durchscheinend ausgebildet sein.

Es ist aber auch möglich farbige Lichtquellen zu verwenden.

Bei lichtundurchlässiger erster Leiterplatte und/oder zum Erreichen eines besonders geringen Lichtverlusts kann die erste Leiterplatte in den Bereichen der durchscheinenden Bereiche den durchgehenden Bereichen entsprechende durchgehende Ausnehmungen aufweisen, die von den Lichtleitern abgedeckt sind.

Sind auf der dem Beobachter abgewandten Seite der ersten Leiterplatte in den Bereichen der durchscheinenden Bereiche zweite Lichtleiter aufgebracht, so führt dies zu einer erhöhten Lichtausbeute des von den Lichtquellen erzeugten und zum Beobachter hin geleiteten Lichts.

Dazu können vorzugweise die zweiten Lichtleiter die Lichtschächte weitgehend bis zur zweiten Leiterplatte hin durchragen.

In einfacher Weise können die ersten Lichtleiter und/oder die zweiten Lichtleiter durch Kleben oder durch Aufspritzen auf die erste Leiterplatte aufgebracht sein.

Bauteilsparend können die einander zugeordneten ersten Lichtleiter und zweiten Lichtleiter einteilig ausgebildet sein.

Ausführungsbeispiele der Erfindung sind in der Zeichnung dargestellt und werden im Folgenden näher beschrieben. Es zeigen
- Figur 1:: eine perspektivische Schnittansicht eines ersten Ausführungsbeispiels eines kapazitiven AnnäherungsSensors,
- Figur 2:: eine perspektivische Schnittansicht eines zweiten Ausführungsbeispiels eines kapazitiven AnnäherungsSensors,

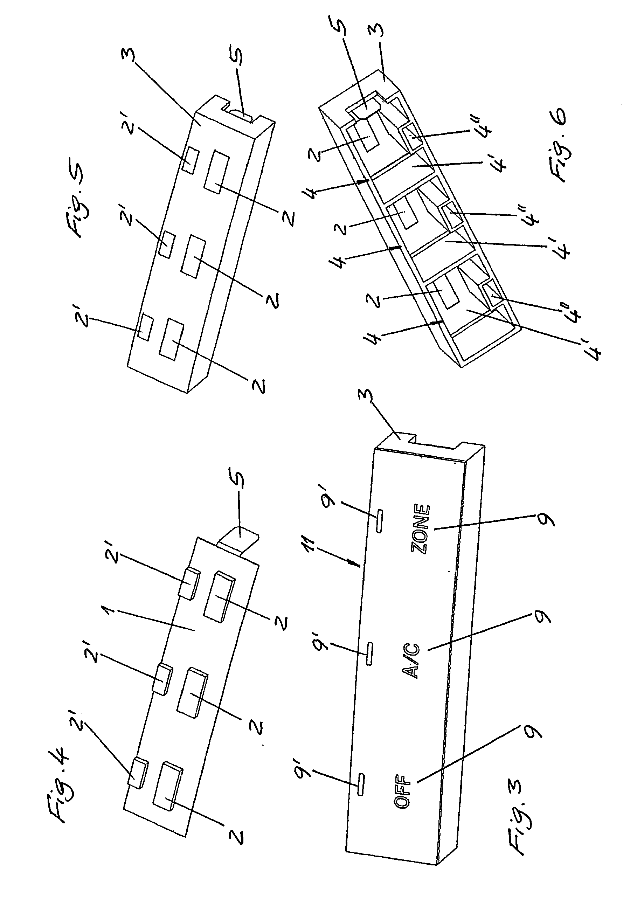

- Figur 3:: eine perspektivische Vorderansicht eines Annäherungssensors nach den Figuren 1 und 2 ohne zweiter Leiterplatte,
- Figur 4:: eine perspektivische Ansicht einer ersten Leiterplatte des Annäherungssensors nach Figur 1,
- Figur 5:: eine perspektivische Vorderansicht des Annäherungssensors nach Figur 1 ohne Dekorschicht und zweiter Leiterplatte,
- Figur 6:: eine perspektivische Rückansicht des Annäherungssensors nach Figur 5.

Die dargestellten Annäherungssensoren weisen eine erste Leiterplatte 1 auf, die als flexible Leiterplatte ausgebildet ist, welche nicht dargestellte Leiterbahnen und kapazitätsbildende Sensorschichten trägt.

Die erste Leiterplatte 1 ist lichtdurchlässig ausgebildet.

Die Sensorschichten sind ebenso transparent ausgebildet und können sog. ITO-Schichten (Indium-Zinn-Oxyd-Schichten) sein.

Sowohl auf die Sensorschichten als auch in einem Abstand neben die Sensorschichten sind durch Aufspritzen erste Lichtleiter 2 und weitere erste Lichtleiter 2' auf die Leiterplatte 1 aufgebracht.

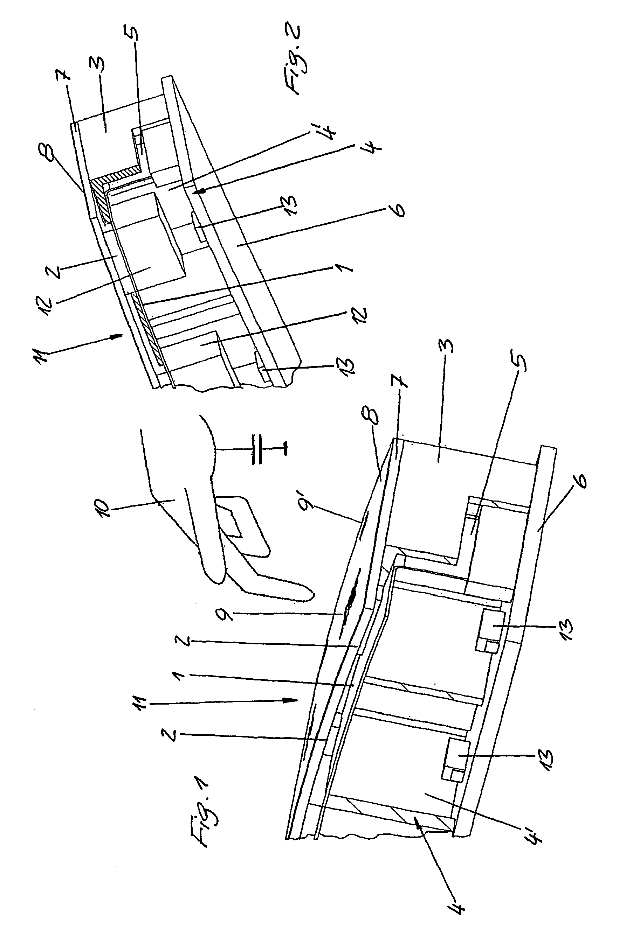

Bei dem Ausführungsbeispiel der Figur 2 sind auf der dem Beobachter abgewandten Seite der ersten Leiterplatte 1 zweite Lichtleiter 12 aufgebracht, die auf der dem Beobachter abgewandten Seite der ersten Leiterplatte 1 die ersten Lichtleiter 2 fortsetzen.

Nach dem Vorgang des Aufbringens der Lichtleiter 2, 2', 12 wurde die erste Leiterplatte 1 in eine Spritzgießform eingelegt und mit einem kastenartigen Funktionsträger 3 aus lichtundurchlässigem Kunststoff umspritzt, wobei der Bereich der ersten Lichtleiter 2 und der weiteren ersten Lichtleitern 2' beidseitig der ersten Leiterplatte 1 ausgespart bleiben und der beobachterseitig die erste Leiterplatte 1 überdeckende Bereich des Funktionsträgers 3 die gleiche Dicke wie die ersten Lichtleiter 2 und die weiteren ersten Lichtleiter 2' aufweist.

Auf der einem Beobachter abgewandten Seite der ersten Leiterplatte 1 bildet der Funktionsträger 3 Lichtschächte 4. Dabei ist jedem einer Sensorschicht zugeordnet Paar aus ersten Lichtleitern und weiteren ersten Lichtleitern 2 und weiteren ersten Lichtleitern 2' ein Lichtschacht 4 zugeordnet.

Die Lichtschächte 4 sind noch einmal in erste Lichtschächte 4' und zweite Lichtschächte 4" unterteilt, wobei die ersten Lichtschächte 4' zu den auf den Sensorschichten angeordneten ersten Lichtleitern 2 und die zweiten Lichtschächte 4" zu den weiteren ersten Lichtleitern 2' führen.

Ein ein Kontaktelement 5 bildender Fortsatz der ersten Leiterplatte 1 ist aus der Ebene der ersten Leiterplatte 1 rechtwinklig zu der dem Beobachter abgewandten Seite abgebogen und bis auf sein freies Ende in den Funktionsträger 3 eingespritzt.

Die Lichtschächte 4 sind auf ihrer dem Beobachter abgewandten Seite von einer gemeinsamen zweiten Leiterplatte 6 verschlossen, die an dem Funktionsträger 3 befestigt ist.

Auf dieser über das Kontaktelement 5 mit der ersten Leiterplatte 1 verbundenen zweiten Leiterplatte 6 sind in jedem Lichtschacht 4' und 4" LED's 13 angeordnet.

Beobachterseitig sind die Lichtleiter 2, 2' und der Funktionsträger 3 mit einer dünnen transparenten Kunststoffschicht 7 überspritzt.

Auf diese Kunststoffschicht ist wiederum eine als Lackschicht ausgebildete lichtundurchlässige Dekorschicht 18 aufgebracht, wodurch ein Anzeigefeld 11 gebildet ist.

Durch Lasern der Dekorschicht 8 über den ersten Lichtleiter 2 und 2' sind Durchbrüche 9, 9' erzeugt, die über den ersten Lichtleitern 2 Bezeichnungen aus Buchstaben und über den weiteren ersten Lichtleitern 2' Lichtbalken bilden.

Die Oberfläche der Dekorschicht 8 kann zum Schutz noch von einem Transparentlack überdeckt sein.

Nähert sich der Beobachter mit einem Finger seiner Hand 10 einer der Bezeichnungen aus Buchstaben auf dem Anzeigefeld 11, führt dies zu einer Kapazitätsänderung an der dieser Bezeichnung zugeordneten Sensorschicht, die erfasst wird und über eine nicht dargestellte Steuereinheit eine Funktion an einem elektrischen oder elektronischen Gerät auslöst.

Durch die angesteuerten LED's werden über die ersten Lichtleiter 2 die Durchbrüche 9 und über die weiteren ersten Lichtleiter 2' die Durchbrüche 9' durchleuchtet.

## Patentansprüche

1. Kapazitiver Annäherungssensor mit einem einen oder mehrere durchscheinende Bereiche aufweisenden Anzeigefeld (11), auf deren einem Beobachter abgewandter Seite eine erste Leiterplatte (1) angeordnet ist, die zumindest im Bereich der durchscheinenden Bereiche des Anzeigefelds (11) lichtdurchscheinend ausgebildet ist und kapazitätsbildende, transparent ausgebildete Sensorschichten trägt, mit Lichtschächten (4, 4', 4''), die auf der dem Beobachter abgewandten Seite die Sensorschichten umschließen und von der ersten Leiterplatte (1) bis zu einer sich in einem Abstand parallel zur ersten Leiterplatte (1) erstreckenden zweiten Leiterplatte (6) ragen, wobei auf der zweiten Leiterplatte (6) innerhalb der Lichtschächte (4, 4', 4'') Lichtquellen angeordnet sind und wobei von der ersten Leiterplatte (1) ein Kontaktelement zur zweiten Leiterplatte (6) geführt ist, wobei beobachterseitig auf die erste Leiterplatte (1) in den Bereichen der durchscheinenden Bereiche Lichtleiter (2, 2') aufgebracht sind und die erste Leiterplatte (1) von einem Funktionsträger (3) aus lichtundurchlässigem Kunststoff auf der Beobachterseite mit gleicher Dicke wie die Lichtleiter (2, 2'), die Bereiche der Lichtleiter (2, 2') beidseitig auf der ersten Leiterplatte (1) aussparend und auf der dem Beobachter abgewandten Seite die Lichtschächte (4, 4', 4'') bildend umspritzt ist, mit einer beobachterseitig die Lichtleiter (2, 2') und den Funktionsträger (3) überdeckenden, lichtundurchlässigen Dekorschicht (8), die als Lackschicht ausgebildet und auf eine Kunststoffschicht (7) aufgebracht ist, wodurch das Anzeigefeld (11) gebildet ist, und die in den Bereichen der durchscheinenden Bereiche Zeichen und/oder Symbole bildende Durchbrüche (9, 9') aufweist, wobei die zweite Leiterplatte (6) an der dem Beobachter abgewandten Seite des Funktionsträgers (3) befestigt ist und wobei erste Lichtleiter (2) und weitere erste Lichtleiter (2') sowohl auf die Sensorschichten als auch in einem Abstand neben die Sensorschichten durch Aufspritzen aufgebracht sind.

2. Annäherungssensor nach Anspruch 1, **dadurch gekennzeichnet , dass** die Lichtleiter (2, 2') und der Funktionsträger (3) beoabachterseitig überdeckend mit einer transparenten Kunststoffschicht (7) in Foliendicke überspritzt sind, auf die die Dekorschicht (8) aufgebracht ist.

3. Annäherungssensor nach einem der vorhergehenden Ansprüche, **dadurch gekennzeichnet, dass** die erste Leiterplatte (1) eine flexible Leiterplatte ist.

4. Annäherungssensor nach einem der vorhergehenden Ansprüche, **dadurch gekennzeichnet, dass** die Lichtleiter (2, 2') einfarbig oder mehrfarbig durchscheinend ausgebildet sind.

5. Annäherungssensor nach einem der vorhergehenden Ansprüche, **dadurch gekennzeichnet, dass** die erste Leiterplatte in den Bereichen der durchscheinenden Bereiche den durchgehenden Bereichen entsprechende durchgehende Ausnehmungen aufweisen, die von den Lichtleitern abgedeckt sind.

6. Annäherungssensor nach einem der vorhergehenden Ansprüche, **dadurch gekennzeichnet, dass** auf der dem Beobachter abgewandten Seite der ersten Leiterplatte (1) in den Bereichen der durchscheinenden Bereiche zweite Lichtleiter (12) aufgebracht sind.

7. Annäherungssensor nach Anspruch 6, **dadurch gekennzeichnet, dass** die zweiten Lichtleiter (12) die Lichtschächte (4) weitgehend bis zur zweiten Leiterplatte (6) hin durchragen.

8. Annäherungssensor nach einem der vorhergehenden Ansprüche, **dadurch gekennzeichnet, dass** die ersten Lichtleiter (2, 2') und/oder die zweiten Lichtleiter (12) durch Kleben oder durch Aufspritzen auf die erste Leiterplatte (1) aufgebracht sind.

9. Annäherungssensor nach einem der Ansprüche 1 bis 8, **dadurch gekennzeichnet, dass** die einander zugeordneten ersten Lichtleiter und zweiten Lichtleiter einteilig ausgebildet sind.

## Claims

1. Capacitive proximity sensor with a display field (11) which has one or more transparent regions and on whose side facing away from an observer a first printed circuit board is arranged, said printed circuit board (1) being translucent at least in the region of the transparent regions of the display field (11) and having capacitance-forming transparent sensor layers, with light shafts (4, 4', 4'') which surround the sensor layers on the side facing away from the observer and project from the first printed circuit board (1) to a second printed circuit board (6) extending at a distance parallel to the first printed circuit board (1), light sources being arranged inside the light shafts (4, 4', 4'') on the second printed circuit board (6), and a contact element being led from the first printed circuit board (1) to the second printed circuit board (6),
optical waveguides (2, 2') being applied to the observer side of the first printed circuit board (1) in the regions of the transparent regions and the first printed circuit board (1) being encapsulated on the observer side by a functional carrier (3) made of opaque plastic with the same thickness as the optical waveguides (2, 2'), omitting the regions of the optical waveguides (2, 2') on both sides of the first printed circuit board (1) and forming the light shafts (4, 4', 4'') on the side facing away from the observer, with an opaque decorative layer (8) which covers the optical waveguides (2, 2') and the functional carrier (3) on the observer side and is in the form of a varnish layer and is applied to a plastic layer (7), whereby the display field (11) is formed, and has apertures (9, 9') forming characters and/or symbols in the regions of the transparent regions, the second printed circuit board (6) being fastened to that side of the functional carrier (3) which faces away from the observer, and first optical waveguides (2) and further first optical waveguides (2') being applied both to the sensor layers and at a distance next to the sensor layers by means of spraying-on.

2. Proximity sensor according to Claim 1, **characterized in that** the optical waveguides (2, 2') and the functional carrier (3) are spray-coated on the observer side such that they are covered with
a transparent plastic layer (7) of film thickness, to which the decorative layer (8) is applied.

3. Proximity sensor according to one of the preceding claims, **characterized in that** the first printed circuit board (1) is a flexible printed circuit board.

4. Proximity sensor according to one of the preceding claims, **characterized in that** the optical waveguides (2, 2') are transparent in one or more colors.

5. Proximity sensor according to one of the preceding claims, **characterized in that** the first printed circuit board has, in the regions of the transparent regions, continuous recesses which correspond to the continuous regions and are covered by the optical waveguides.

6. Proximity sensor according to one of the preceding claims, **characterized in that** second optical waveguides (12) are applied to that side of the first printed circuit board (1) which faces away from the observer in the regions of the transparent regions.

7. Proximity sensor according to Claim 6, **characterized in that** the second optical waveguides (12) project through the light shafts (4) largely up to the second printed circuit board (6).

8. Proximity sensor according to one of the preceding claims, **characterized in that** the
first optical waveguides (2, 2') and/or the second optical waveguides (12) are applied to the first printed circuit board (1) by means of adhesive bonding or spraying-on.

9. Proximity sensor according to one of Claims 1 to 8, **characterized in that** the first optical waveguides and second optical waveguides associated with one another are formed in one part.

## Revendications

1. Capteur de proximité capacitif, comprenant une console (11) de visualisation, qui a une ou plusieurs parties translucides et, sur la face éloignée de l'observateur de laquelle est disposée une première plaquette (1) à circuit imprimé, qui est translucide à la lumière, au moins dans la région des parties translucides de la console (11) de visualisation, et qui porte des couches de capteur constituées de manière à former une capacité et transparentes, comprenant des puits (4, 4', 4'') de lumière, qui, sur la face éloignée de l'observateur, entourent les couches de capteur et qui vont de la première plaquette (1) à circuit imprimé jusqu'à une deuxième plaquette (6) à circuit imprimé s'étendant à distance parallèlement à la première plaquette (1) à circuit imprimé, des sources lumineuses étant disposées à l'intérieur des puits (4, 4', 4'') de lumière sur la deuxième plaquette (6) à circuit imprimé et un élément de contact allant de la première plaquette (1) à circuit imprimé à la deuxième plaquette (6) à circuit imprimé, dans lequel il est déposé, du côté de l'observateur sur la première plaquette (1) à circuit imprimé, dans les régions des parties translucides, des fibres (2, 2') optiques et la première plaquette (1) à circuit imprimé est recouverte, par extrusion, d'un support (3) de fonction en matière plastique opaque à la lumière, du côté observateur, d'une même épaisseur que les fibres (2, 2'') optiques épargnant les parties des fibres (2, 2') optiques des deux côtés de la plaquette (1) à circuit imprimé et formant les puits (4, 4', 4'') de lumière du côté éloigné de l'observateur, comprenant une couche (8) décorative opaque, qui recouvre, du côté de l'observateur, les fibres (2, 2'') optiques et le support (3) de fonction, qui est constituée en couche de vernis et qui est déposée sur une couche (7) en matière plastique, la console (11) de visualisation étant ainsi formée, et qui a des traversées (9, 9') formant des signes et/ou des symboles dans les régions des parties translucides, la deuxième plaquette (6) à circuit imprimé étant fixée à la face du support (3) de fonction, éloignée de l'observateur, et dans lequel une première fibre (2) optique et d'autres premières fibres (2') optiques sont déposées, tant sur les couches de capteur qu'également à distance à côté des couches de capteur, par surmoulage.

2. Capteur de proximité suivant la revendication 1, **caractérisé en ce que** les fibres (2, 2') optiques et le support (3) de fonction sont à recouvrement, du côté de l'observateur, surmoulés d'une couche (7) de matière plastique transparente en une épaisseur de feuille, couche sur laquelle est déposée la couche (8) décorative.

3. Capteur de proximité suivant l'une des revendications précédentes, **caractérisé en ce que** la première plaquette (1) à circuit imprimé est une plaquette à circuit imprimé souple.

4. Capteur de proximité suivant l'une des revendications précédentes, **caractérisé en ce que** les fibres (2, 2') optiques sont translucides en ayant une seule couleur ou plusieurs couleurs.

5. Capteur de proximité suivant l'une des revendications précédentes, **caractérisé en ce que** les premières plaquettes à circuit imprimé ont, dans les régions des parties translucides, des évidements, qui correspondent aux parties continues et qui sont recouverts par les fibres optiques.

6. Capteur de proximité suivant l'une des revendications précédentes, **caractérisé en ce que**, sur la face éloignée de l'observateur de la première plaquette (1) à circuit imprimé, des deuxièmes fibres (12) optiques sont déposées dans les régions des parties translucides.

7. Capteur de proximité suivant la revendication 6, **caractérisé en ce que** les deuxièmes fibres (12) optiques passent dans les puits (4) de lumière en allant loin jusqu'à la deuxième plaquette (6) à circuit imprimé.

8. Capteur de proximité suivant l'une des revendications précédentes, **caractérisé en ce que** les premières fibres (2, 2') optiques et/ou les deuxièmes fibres (12) optiques sont déposées par collage ou par surmoulage sur la première plaquette (1) à circuit imprimé.

9. Capteur de proximité suivant l'une des revendications 1 à 8, **caractérisé en ce que** les premières fibres optiques et les deuxièmes fibres optiques associées les unes aux autres sont constituées d'un seul tenant.
